Europäisches Patentamt

European Patent Office

Office européen des brevets

(11) Publication number: **0 213 854**
A2

# (12) EUROPEAN PATENT APPLICATION

(21) Application number: 86306290.7

(22) Date of filing: 14.08.86

(51) Int. Cl.⁴: **G 06 F 7/52**
**H 03 M 7/06**

(30) Priority: 28.08.85 GB 8521375

(43) Date of publication of application:
11.03.87 Bulletin 87/11

(84) Designated Contracting States:
DE FR IT NL SE

(71) Applicant: PLESSEY OVERSEAS LIMITED
Vicarage Lane
Ilford Essex IGI 4AQ(GB)

(72) Inventor: Dyer, Nigel Paul
36 Grange Road
Chiswick London W4 4DD(GB)

(74) Representative: Sorenti, Gino
Intellectual Property Department The Plessey Company
plc 2-60 Vicarage Lane
Ilford Essex IG1 4AQ(GB)

(54) Fixed-Coefficient serial multiplication and digital circuits therefor.

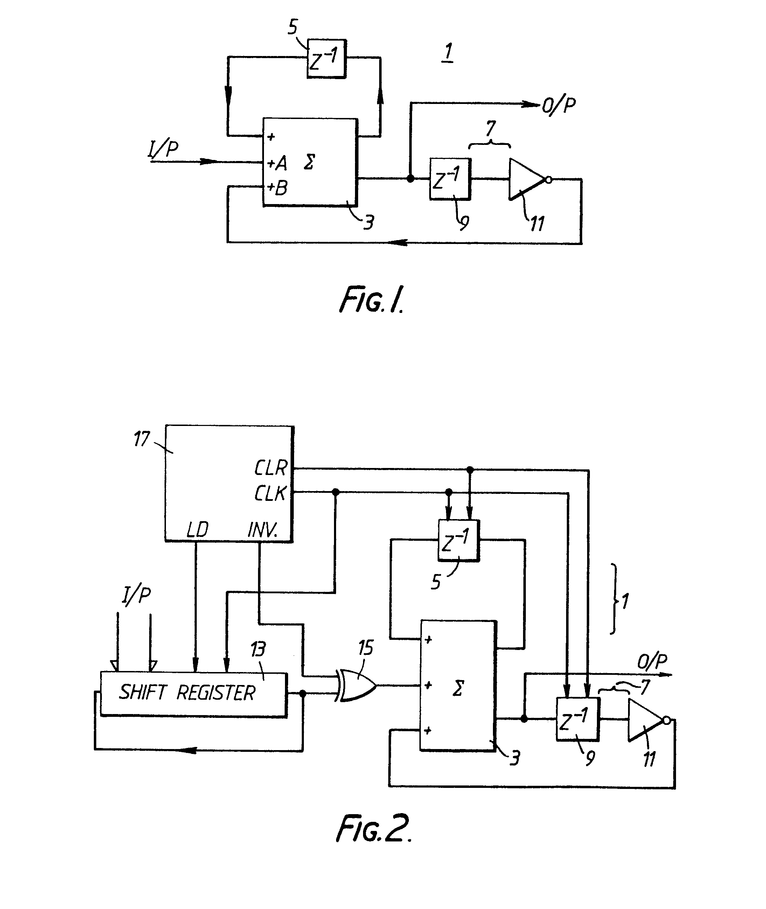

(57) A digital circuit (Figure 2) including a full adder (3) with a carry-bit latch (5) and provided with a delay-and-substract feedback network (7) including at least one delay element (9) and an inverter (11). The states of the latch (5) and delay element (9) may be preset to afford multiplicand correction and product truncation. The product is extracted at the adder output. The circuit also includes a control logic unit (17), for controlling series operation of the system. A shift register (13) and exclusive-or gate (15) are used in the multiplicand input path. Using these latter components the states of the latch and delay element are preset by a pre-run pass of the mutiplicand through the adder (3) and network (7).

A binary-to-ternary converter (Figure 5) is also disclosed comprising a pair of divide-by-three coefficient multiplier circuits configured in tandem.

-1-

## Fixed-coefficient serial multiplication and digital circuits therefor.

### Technical Field

The present invention concerns methods of fixed-coefficient serial multiplication and digital circuits, especially but not exclusively, divide-by-three binary processing circuits.

One of the common building blocks utilised in Digital Signal Processing Systems (DSP) is a multiplier – a digital circuit for multiplying binary data words by either another binary data word, or by a fixed coefficient.

Of especial interest are digital circuits specifically designed for multiplying by the fixed coefficient 1/3. Potential areas of application of these circuits include:

i)   Digital filters requiring the use of the coefficient 1/3; and,

ii)   Systems for converting from base 2 (binary) number representation to base 3 (ternary) number representation.

### Background Art

It has hitherto been common practice to employ an array comprised of numerous binary full adders to implement coefficient multiplication. For a comprehensive review of this art, the reader is referred to the article "Theory and Application of Digital Signal Processing" by L.R.Rabiner and B.Gold, pub. Prentice-Hall (1975) pages 514-524. As typical of this art, for N-bit data word processing, an (N/2)(N-1) adder array has been used for fixed-coefficient parallel multiplication, and, an N/2 adder and N-bit latch array has been used for fixed-coefficient serial multiplication. In the design of Large Scale Integration (LSI) devices such adders occupy substantial chip space and the requirement for such large numbers is clearly a disadvantage.

Disclosure of the Invention

The present invention is intended as a simple alternative to the foregoing. In the basic implementation of this invention, a single full adder, only, is requisite.

According to one aspect of the present invention there is provided a method of fixed-coefficient serial multiplication wherein the bits of a first digitally encoded word, the multiplicand, are applied sequentially to one input of a full adder, producing a sequential bit output signal, this output signal is delayed bit by bit, an integer number of cycle intervals, inverted, and applied to another input of the full adder, thereby producing at the output of the full adder a second digitally encoded word, the product term.

In the method aforesaid, the fixed-coefficient is determined by the number of cycle intervals by which the output signal bits are each delayed. Thus, for example, fixed-coefficient "one-third" (ie. divide-by-three) multiplication can be achieved by introducing a single cycle interval delay. In similar manner, a fixed-coefficient of $1/(2n+1)$ corresponds to a delay of n cycle intervals. Where the multiplicand and multiplier coefficient are integer related, the product term produced is a digitally encoded integer. Where the terms are not so related, the word generated is a digitally encoded composite comprising the sum of an integer component of finite word length and a non-integer component of infinite word length, similar to recurrent fraction. Thus, in the case given as example above, divide-by-three multiplication, the product term is comprised of an integer component and a diadic component. Whilst it is possible to process such a compound product term to provide any truncation or rounding as may be requisite, a preferred approach is to modify the multiplicand to give a simple integer result.

In accordance thus with another aspect of this invention there is provided a preferred method of fixed-coefficient serial multiplication wherein in the method aforesaid the multiplicand is first processed to determine a value dependant correction term for the multiplicand,

-4-

and, following this determination, the multiplicand is both corrected and applied to the full-adder to produce at the adder output an integer word product.

Whilst the preferred aforesaid method may be performed by applying correction to modify the multiplicand prior to any application of the multiplicand to the adder, it is both convenient and advantageous to apply the multiplicand and correction term to separate inputs of the adder, thereby performing both multiplicand correction and coefficient multiplication simultaneously.

The preferred method may be performed using a full adder-and-feedback-network to generate the requisite correction term, and by using a full adder-and-feedback-network to perform the multiplicand correction and coefficient multiplication. It is furthermore convenient to process the multiplicand in two sequential steps using a common full adder-and-feedback-network to perform both correction term generation and correction/multiplication steps of this method.

In accordance with a further aspect of this invention there is provided a digital circuit for performing fixed-coefficient serial multiplication, the circuit comprising:

a full adder;

a delay-and-invert feedback network connected between the

-5-

output of the adder and one input thereof; and,

first control means connected to the adder and to the network, for controlling serial operation of the same.

In the circuit aforesaid, the full adder comprises a carry bit latch and the feedback network includes one or more delay bit storage elements. The product term produced by operation of this circuit will depend not only on the value of the multiplicand, but will also depend upon the initial states of the latch and the delay bit storage element or elements. It will be shown below that this latter dependancy may be utilised to afford in-process multiplicand correction, to suppress the generation of imperfect fraction product terms. In an improved variant of the above circuit, multiplicand responsive control means is provided to determine the initial states of the latch and storage element or elements, to afford the requisite multiplicand correction.

As discussed in more detail below, there is provided a divide-by-three digital circuit comprising:-

a full adder including a carry bit latch;

a feedback network connected between the adder output and a first input thereof, the same being comprised of a unit interval delay storage element and an inverter; a multiplicand repeater (for example, a shift register) connected to a second input of the adder;

-6-

an exclusive-or gate interposed between the repeater and the adder; and,

control logic means for governing operation of the repeater, the gate, the latch, and, the storage element.

The divide-by-three circuit disclosed above is suited to processing binary coded multiplicands of odd word length, both positive and negative (2's compliment). First-pass operation of this circuit results in overflow storage in the carry latch and the delay storage element. At the initiation of second pass operation these are in the requisite states for affording multiplicand correction.

The divide-by-three circuit mentioned, offers advantages where a dedicated circuit is required and the number of circuit elements must be kept to a minimum. It is noted that a circuit clock rate of at least 2*N times the rate at which multiplications are to be formed, is requisite. This circuit therefore has potential application in the design of LSI devices where semiconductor (eg. silicon) area must be kept to a minimum, but where system clock rates of many mega-hertz are available to take advantage of the fast operating speeds of current CMOS technology.

Brief Introduction of the Drawings

In the drawings accompanying this specification:-

Figure 1 is a block circuit diagram showing the basic components of a multiplier based on the principle of the present invention;

Figure 2 is a block circuit diagram showing a completed circuit for the multiplier of the preceding figure;

Figure 3 is a timing diagram showing clock and control signal waveforms (a) to (d) for operating the multiplier of the preceding figure;

Figure 4 is a block circuit diagram showing a modification of the input configuration of the multiplier shown in figure 2 above;

Figure 5 is a block circuit diagram of a full circuit for a binary-to-ternary code converter based on the multiplier shown in figure 2 above; and,

Figure 6 is a timing diagram showing clock and control signal waveforms (a) to (f) for operating the converter of the preceding figure.

Description of the Preferred Embodiments

Embodiments of this invention will now be described, by way of example only, with reference to the accompanying drawings.

The basic components of a divide-by-three digital circuit 1 are shown in figure 1. This circuit 1, comprises a full binary adder 3 complete with a carry-bit

-8-

latch 5, and, also a feedback network 7 comprised of a unit interval delay element 9 and an inverter 11. The feedback network 7 is connected between the output 8 of the adder 3 and one of the inputs B of this adder 3. The multiplicand is applied serially to the other input A of this adder 3.

Principle of operation

For divide-by-three processing, the required system transfer function can be written $Y = X/3$ where $X$ is the binary input word and $Y$ the required output. This can be rewritten:

$$3 * Y = X$$

ie. $Y = X - (2 * Y)$

This equation defines the output, $Y$, in terms of itself which is normally impossible to implement in a causal system. However, closer examination shows that it is the value $2 * Y$ that it is required, and in a serial system, this is equivalent to a delay of one clock cycle, ie. the output of the system is delayed by one clock cycle and substracted from the input.

(By way of generalisation it is noted here that for divide-by-$(2M+1)$ processing, the transfer function can be written in the form:-

$Y = X - (2M * Y)$, and this may be implemented by introducing a delay of $M$ clock cycles).

Unfortunately, there is a major drawback with this basic system, in that it will only generate a finite product term if the multiplicand is an integer that is divisible by three. All other integers generate a number which is the sum of the required result and the diadic representation of the remainder, divided by three. The diadic number system results from the ability to represent fractional binary numbers in the following form:

......010101010101 (base 2) = -1/3

......101010101010 (base 2) = -2/3

It is possible to modify the circuit 1 so it does not generate diadic numbers, and can cope with both positive and negative binary input numbers. The first modification is to restrict the circuit 1 to only using odd (3,5,7,9 etc) word lengths for the input and therefore also the output binary data words. The next modification is to arrange for the input word to be processed through the system twice. The first run through generates an unwanted diadic representation of the result, but leaves the carry bit and delay bit storage elements in such a way that if they are used as the initial conditions for the next run through then the output is the required result. The final modification is the inversion of the sign bit, or most significant bit to enable the system to operate with both positive and negative binary numbers.

Implementation

Figure 2 illustrates a complete circuit for implementing the divide-by-three function. It consists of the following circuit elements:

An N-bit shift register 13 for storing the input binary word;

An exclusive-or gate 15 for inverting the most significant bit of the input word;

A binary full adder 3;

A Carry bit latch 5, a component of the binary adder 3;

A single bit delay element 9;

An inverter 11 for inverting the output of the delay element 9; and,

Control logic 17 for providing the correct sequence of signals for driving the circuit.

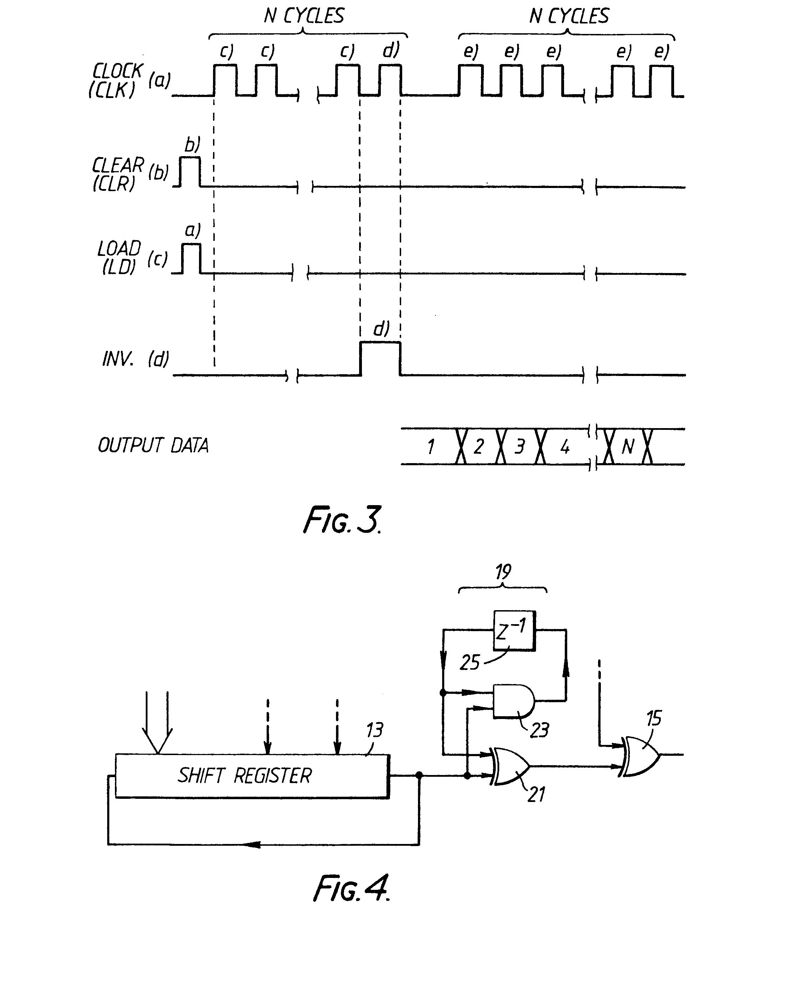

The sequence of operation required for driving the circuit is as follows, the associated waveforms generated by the Control Logic 17 being shown in figure 3.

a) The number to be divided by three, the multiplicand, is loaded into the shift register 13. This can be achieved by loading the word in parallel, or by shifting the word in from the end of the shift register 13. If the word is shifted in this can be performed at the same time as operation e. below.

b) The carry bit latch 5 and delay element 9 are cleared.

c)    N-1 clock cycles are applied to the system.  At each clock cycle, the output from the shift register 13 passes straight through the exclusive-or gate 15, where it is added to the carry bit and the inverted signal from the delay element 9 and the result stored in the delay element 9, with any carry stored in the carry bit latch 5.  During this process, the output from the shift register 13 is fed back to the input so that the binary word can be used again.

d)    For the final clock cycle, the operation is exactly as described in c) except that the input from the shift register 13 to the serial adder 3 is inverted by the exclusive-or gate 15.

e)    The data stored in the carry bit latch 5 and delay element 9 is left unchanged, and a further N clock cycles are applied to the system.  The circuit operation is as described in c), except that it is unnecessary to re-store the input binary word as it is shifted out of the shift register 13 and the sign bit is not inverted in the manner described in section d.  The output is available in serial form at the output from the full adder 3.

The following table shows the input and associated outputs from such a system, and indicates the values of the carry and delay bit after the system has finished operation d).  This illustrates that the output is truncated, not rounded.

TABLE 1

| Input to circuit (Multiplicand) Binary (Dec) | Output from circuit (Product) Binary (Dec) | Storage States Carry | Delay (After First N cycles) |
|---|---|---|---|
| 10110 ( -10) | 11100 ( -4) | 0 | 1 |
| 10111 ( -9) | 11101 ( -3) | 1 | 0 |
| 11000 ( -8) | 11101 ( -3) | 0 | 0 |
| 11001 ( -7) | 11101 ( -3) | 0 | 1 |
| 11010 ( -6) | 11110 ( -2) | 1 | 0 |
| 11011 ( -5) | 11110 ( -2) | 0 | 0 |
| 11100 ( -4) | 11110 ( -2) | 0 | 1 |
| 11101 ( -3) | 11111 ( -1) | 1 | 0 |
| 11110 ( -2) | 11111 ( -1) | 0 | 0 |
| 11111 ( -1) | 11111 ( -1) | 0 | 1 |
| 00000 ( +0) | 00000 ( +0) | 1 | 0 |
| 00001 ( +1) | 00000 ( +0) | 1 | 1 |
| 00010 ( +2) | 00000 ( +0) | 0 | 1 |
| 00011 ( +3) | 00001 ( +1) | 1 | 0 |
| 00100 ( +4) | 00001 ( +1) | 1 | 1 |
| 00101 ( +5) | 00001 ( +1) | 0 | 1 |
| 00110 ( +6) | 00010 ( +2) | 1 | 0 |
| 00111 ( +7) | 00010 ( +2) | 1 | 1 |
| 01000 ( +8) | 00010 ( +2) | 0 | 1 |
| 01001 ( +9) | 00011 ( +3) | 1 | 0 |
| 01010 ( +10) | 00011 ( +3) | 1 | 1 |

-13-

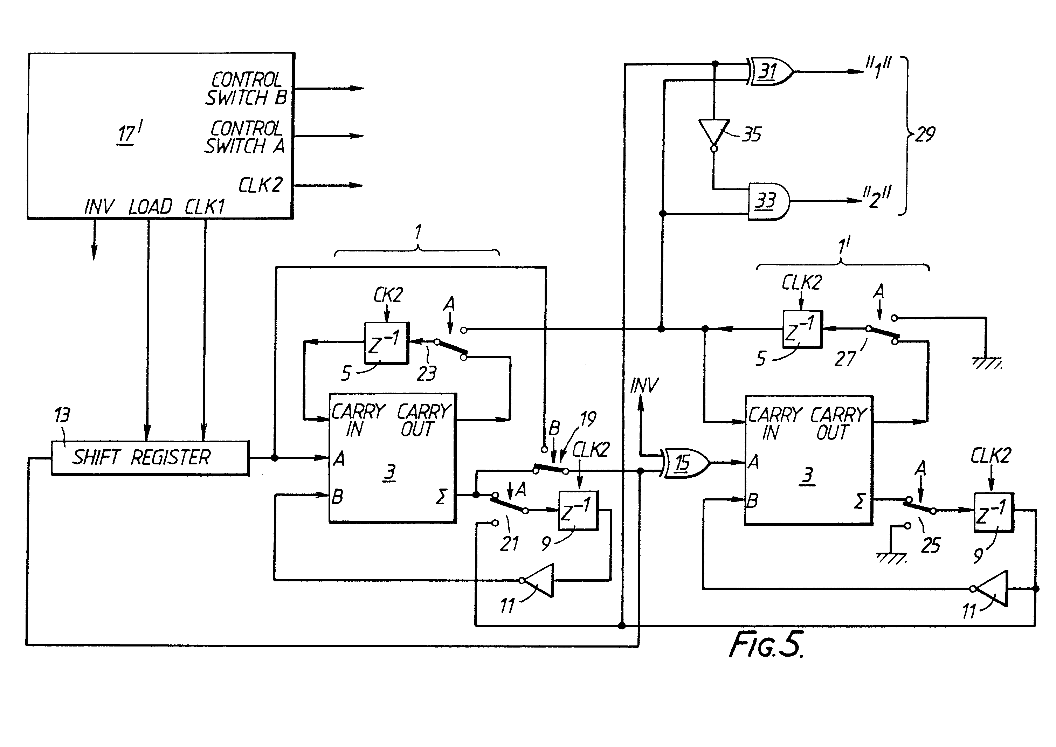

Where a rounding correction is required in place of truncation, an additional multiplicand correction sub-circuit may be interposed between the register 13 and the exclusive-or gate 15. A correction sub-circuit 19 is shown in figure 4 and comprises an Exclusive-OR gate 21, an AND gate 23, and, a unit interval delay element 25. In this arrangement, the signal from the output of the shift register 13 is fed in parallel to the Exclusive-OR 21 and the AND gate 23. The output of the AND gate 23 is connected to the delay element 25 which in turn is connected in parallel to the remaining inputs of the AND gate 23 and the Exclusive-OR gate 25. The output of this Exclusive-OR gate 25 is connected to the Exclusive-OR gate 15 of the multiplier circuit. The start state of the delay element 25 is also controlled by the control logic unit 17 and is set to logic one "1" at the start of each pass, ie. at the start of each cycle of N clock pulses.

An application of the divide-by-three circuit described, a binary-to-ternary code converter, is shown in figure 5. In this converter two adder-feedback circuits 1,1' are utilised. Each circuit comprises a full adder 3 with a carry latch 5 and a feedback network 7 comprised of a unit interval single bit delay element 9 and an inverter 11. One of these circuits, circuit 1, is connected directly to the output of a shift register 13 and is dedicated to ·

-14-

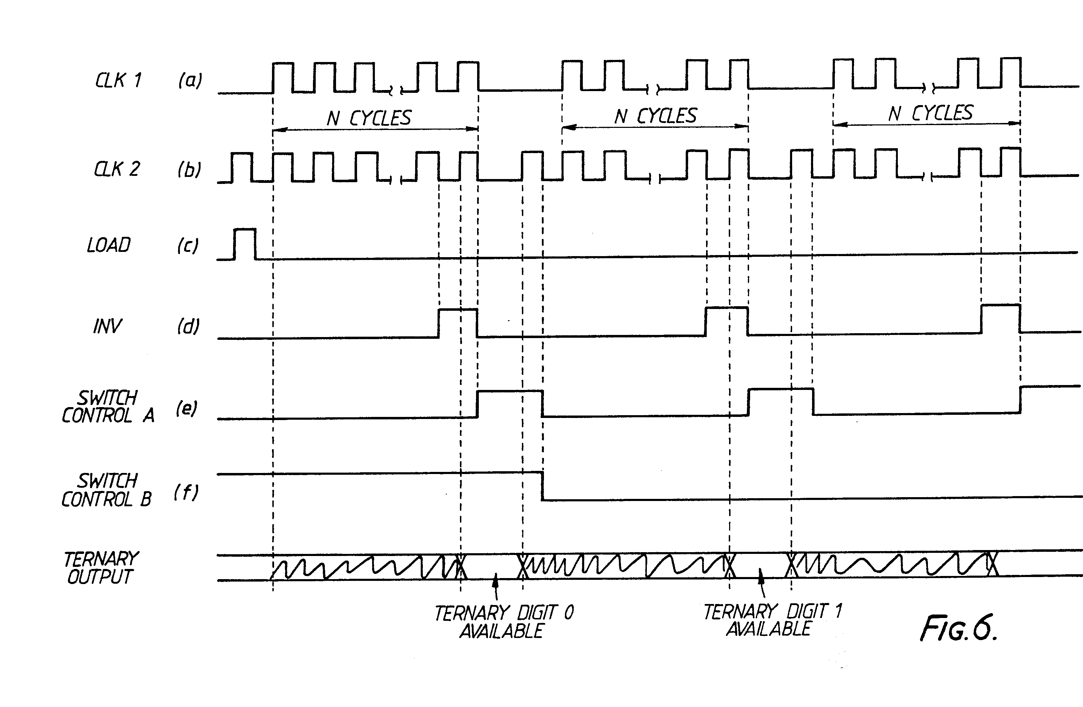

multiplicand correction and multiplication. The other circuit, circuit 1' is connected to the output of the register via a 2-pole switch 19 and an Exclusive-OR gate 15. This circuit 1' is dedicated to correction term (remainder) generation. The carry latches 5, and the storage elements 9, respectively, are interconnected via two 2-pole switches 21,23, to permit bit transfer between the latch 5 and element 9 of the correction term circuit 1' and the latch 5 and element 9 of the multiplier circuit 1. Two further 2-pole switches 25 and 27 are included in the correction term circuit 1', each preceding the latch 5 and element 9. These are used to clear the latch 5 and delay element 9 and are also connected to system earth. As two dedicated circuits 1,1' are employed, consecutive multiplicand processing, ie. consecutive divisions, may be performed concurrently. Operation of the register 13 and switches 19 to 27 is governed by a central control logic unit 17'. The control signals produced by this unit 17' are shown in figure 6. At the end of each series of N-clock cycles the state of the carry latch 5 and delay element 9 of the circuit 1' is examined by means of a coding sub-circuit 29. This comprises an Exclusive-OR gate 31, an AND gate 33 and an inverter 35. The latch 5 and delay element 9 are connected directly to the inputs of the Exclusive-OR gate 31. The latch 5 is also connected to the AND gate 33. The delay element 9 is connected to the AND gate 33 via the inverter 35. Ternary "1" and ternary "2" outputs are provided by the Exclusive-OR gate 31 and the AND gate 33 respectively.

The above converter circuit is designed to convert binary numbers to ternary numbers, where each ternary digit can have a value 0, 1 or 2. The circuit may be adapted to produce ternary numbers where each ternary digit has a value -1, 0, +1. This can be implimented using the input modification shown in figure 4 and a few other minor alterations.

CLAIMS

1. A method of fixed-coefficient serial multiplication wherein the bits of a first digitally encoded word, the multiplicand, are applied sequentially to one input of a full adder, producing a sequential bit output signal, this output signal is delayed bit by bit, an integer number of cycle intervals, inverted, and applied to another input of the full adder, thereby producing at the output of the full adder a second digitally encoded word, the product term.

2. A method, as claimed in claim 1, wherein the multiplicand is first processed to determine a value dependant correction term for the multiplicand, and, following this determination the multiplicand is both corrected and applied to the full-adder to produce at the adder output an integer word product.

3. A method, as claimed in claim 2, wherein the multiplicand and correction term are applied to separate inputs of the adder to perform multiplicand correction and coefficient multiplication simultaneously.

4. A method, as claimed in claim 3, wherein the correction term is generated using a full adder and feedback network.

5. A method, as claimed in claim 4, wherein the correction term is generated and also the multiplicand correction and coefficient multiplication performed using a common full adder and feedback network.

6. A digital circuit for performing fixed-coefficient serial multiplication, the circuit comprising:-

a full adder;

a delay-and-invert feedback network connected between the output of the adder and one input thereof; and,

first control means connected to the adder and to the network, for controlling serial operation of the same.

7. A circuit, as claimed in claim 6, the full adder including a carry bit latch; the feedback network including at least one delay bit storage element; and, multiplicand responsive control means co-operative with the latch and with said storage element, arranged for setting each for multiplicand correction.

8. A divide-by-three digital circuit comprising:-

a full adder including a carry bit latch;

a feedback network connected between the adder output and a first input thereof, the same being comprised of a unit interval delay storage element and an inverter;

a multiplicand repeater connected to a second input of the adder;

an exclusive-or gate interposed between the repeater and the adder; and

control logic means for governing operation of the repeater, the gate, the latch, and the storage element.

9 . A circuit, as claimed in claim 8, wherein the multiplicand repeater comprises a shift register, the output thereof being referred to input for reloading.

10. A circuit, as claimed in claim 9, including a rounding correction sub-circuit interposed between the register and the exclusive-or gate.

11. A binary-to-ternary converter comprising:

a first divide-by-three serial multipler including a full adder with delay negative feedback, for generating remainder terms;

a second divide-by-three serial multiplier for generating an integer produce term for successive multiplication;

a coding-sub-circuit for sampling the remainder;

a shift register for storing a multiplicand; and,

a control logic unit for controlling operation of the register and two multipliers.

FIG.1.

FIG.2.

FIG. 3.

FIG. 4.

0213854

Fig.5.

CLK 1 (a)

CLK 2 (b)

LOAD (c)

INV (d)

SWITCH CONTROL A (e)

SWITCH CONTROL B (f)

TERNARY OUTPUT

N CYCLES

N CYCLES

N CYCLES

TERNARY DIGIT 0 AVAILABLE

TERNARY DIGIT 1 AVAILABLE

Fig.6.

4/4

0213854